# EUROPEAN PATENT APPLICATION

(11) **EP 3 621 147 A1**
(43) Date of publication of application: **11.03.2020**
(21) Application number: 18838647.8
(22) Date of filing: 23.02.2018
(51) Int. Cl.: H01P 3/12, H01L 23/12, H01P 1/04

(54) **CIRCUIT BOARD, WIRELESS DEVICE, AND METHOD FOR MANUFACTURING CIRCUIT BOARD**

(30) Priority: 27.07.2017 JP 2017145052
(71) Applicant: Fujikura Ltd., Tokyo 135-8512 (JP)
(72) Inventor: IWATA, Koichiro, Sakura-shi Chiba 285-8550 (JP)
(74) Representative: Maiwald Patent- und Rechtsanwaltsgesellschaft mbH
(86) International application number: PCT/JP2018/006638
(87) International publication number: WO 2019/021515

(57) **Abstract**

To provide a circuit board of a small size capable of propagating a radio wave between a front surface and a back surface of the circuit board.

A circuit board includes: a through hole that penetrates between a front surface and a back surface of the circuit board; and a waveguide formed in the through hole, the waveguide including a dielectric having a rectangular parallelepiped shape and a conductor covering surfaces other than a first surface and a second surface of the dielectric, the first surface being on a front surface side of the circuit board, the second surface being on a back surface side of the circuit board.

## Description

### [Technical Field]

The present disclosure relates to a circuit board, a wireless device, and a method for manufacturing a circuit board.

### [Background Art]

Wireless communication equipment and industrial equipment sometimes propagate a microwave and a millimeter wave via a hollow square waveguide having a square cross-section or a through hole of a circuit board (for example, see Patent Literature 1).

### [Citation List]

### [Patent Literature]

Patent Literature 1: Japanese Patent Application Publication No. 2004-201163

### [Summary of Invention]

### [Technical Problem]

In order to propagate a radio wave of a TE01 mode through a square waveguide or a through hole, the square waveguide and the like need to have a shape corresponding to a frequency of the radio wave. For example, in a case where a frequency of a radio wave to be propagated is 6 GHz (microwave), a width a is, for example, 25 to 50 mm, the width a being out of the width a and a depth b (a > b) when a square waveguide is placed such that a travel direction of a radio wave traveling therethrough is an up-down direction. Further, in a case where a frequency of a radio wave to be propagated is 60 GHz (millimeter wave), the width a of a square waveguide is, for example, 2.5 to 5.0 mm. The above describes the cases where the microwave or the millimeter wave propagates through the square waveguide, and the same applies to a case where the microwave or the millimeter wave propagates through a through hole penetrating from a front surface to a back surface of a circuit board. Thus, for example, a length of each side of an opening (rectangle) of the through hole that propagates the millimeter wave is about a few millimeters.

However, when a through hole with each side of a few millimeters is formed in a circuit board by cutting processing or the like, the opening may have rounded corners, and it may be difficult to form a rectangular shape. Such a through hole typically cannot propagate a millimeter wave in a desired mode at a desired frequency. Thus, when a millimeter wave is propagated from a front surface side to a back surface side of a circuit board, a square waveguide may penetrate through the circuit board. However, the outer shape of a hollow square waveguide is generally large, and thus, a circuit board size also increases in such a case.

Thus, an objective of the present disclosure is to provide a circuit board of a small size capable of propagating a radio wave between a front surface and a back surface of the circuit board.

### [Solution to Problem]

A main aspect of the present disclosure for achieving an object described above is a circuit board comprising:
a through hole that penetrates between a front surface and a back surface of the circuit board; and
a waveguide formed in the through hole, the waveguide including a dielectric having a rectangular parallelepiped shape and a conductor covering surfaces other than a first surface and a second surface of the dielectric, the first surface being on a front surface side of the circuit board, the second surface being on a back surface side of the circuit board.

### [Advantageous Effects of Invention]

According to the present disclosure, it is possible to provide a circuit board of a small size capable of propagating a radio wave between a front surface and a back surface of the circuit board.

### [Brief Description of Drawings]

[Fig. 1] Fig. 1 is a perspective view illustrating a configuration of a wireless device 10.
[Fig. 2] Fig. 2 is an exploded perspective view of the wireless device 10.
[Fig. 3] Fig. 3 is an exploded perspective view of a circuit board 21.
[Fig. 4] Fig. 4 is a plan view of the circuit board 21.
[Fig. 5] Fig. 5 is a perspective view of an antenna board 20, the circuit board 21, and a waveguide 23.
[Fig. 6] Fig. 6 is a flowchart illustrating one example of a method for manufacturing the circuit board 21.
[Fig. 7] Fig. 7 is a perspective view of a circuit board 25.

### [Description of Embodiments]

### Wireless Device 10

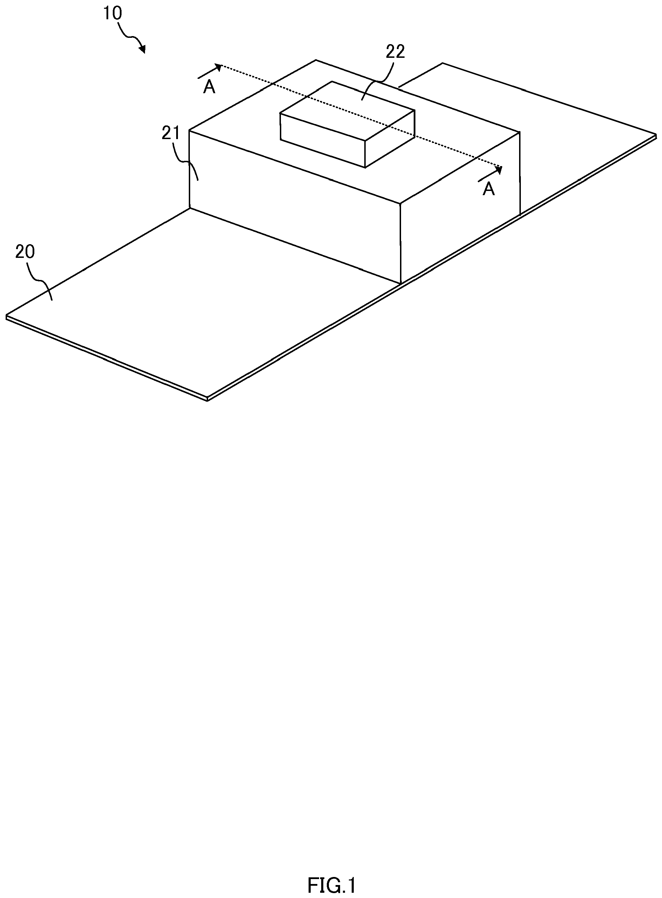

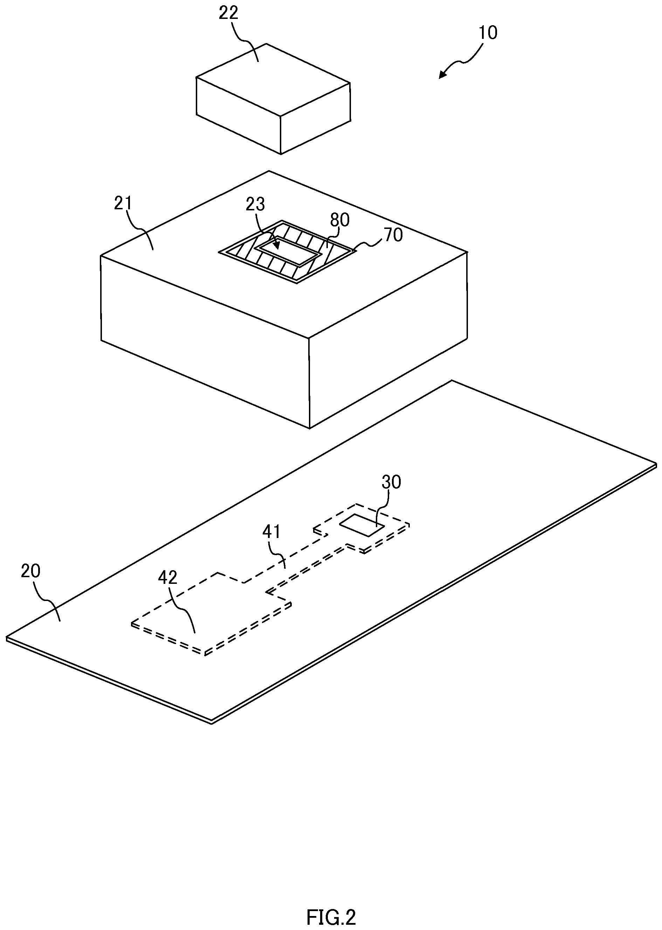

Fig. 1 is a perspective view illustrating a configuration of a wireless device 10. Fig. 2 is an exploded perspective view of the wireless device 10.

The wireless device 10 is a communication device used for transmitting and receiving a radio wave in a millimeter waveband, for example, and includes an antenna board 20, a circuit board 21, a wireless circuit 22, and a waveguide 23.

The antenna board 20 is a printed board on which an antenna and a signal line that transmit and receive a millimeter wave are formed as patterns. A liquid crystal polymer and a fluororesin-based material, for example, may be used as a board material. When the patterns are provided only on a back surface of the antenna board 20, metal foil patterns of a coupling part 30, a signal line 41, and an antenna 42 are provided, the coupling part 30 configured to be electrically coupled to the waveguide 23 in a position facing the waveguide 23 of the circuit board 21. The coupling part 30 is a metal pattern having a rectangular shape or a circular shape, for example, and is configured to be electrically coupled to the waveguide 23 through the antenna board 20. An antenna pattern is, for example, a rectangular pattern. They are designed into shapes capable of achieving desired antenna characteristics. Note that, in an embodiment of the present disclosure, the antenna 42 is provided on the back surface of the antenna board 20, but the present disclosure is not limited thereto. For example, the antenna 42 may be provided on a front surface or a side surface (when the antenna board 20 has a sufficient thickness) of the antenna board 20.

When the antenna board 20 is a multilayer board, the coupling part 30, the signal line 41, and the antenna 42 are appropriately disposed on any one or a plurality of layers of a front surface, a back surface, and an inner layer (s) in combination with interlayer connection and the like by through hole plating and the like between/among layers, thereby being able to control characteristics of an antenna in a high degree. Further, a pattern (not illustrated) for an impedance adjustment may be added. A pattern exposed on a surface may be covered with a protective film (not illustrated) made of resin when an influence on the characteristics is sufficiently small.

The signal line 41 is a wiring that propagates a millimeter wave between the coupling part 30 and the antenna 42.

When the wireless device 10 is a receiving device, the antenna 42 receives a millimeter wave and propagates the millimeter wave to the circuit board 21. When the wireless device 10 is a transmitting device, the antenna 42 radiates a millimeter wave propagated from the circuit board 21 into a space. When the wireless device 10 is a transmitting/receiving device, the antenna 42 receives a millimeter wave and propagates the millimeter wave to the circuit board 21, and also radiates a millimeter wave propagated from the circuit board 21 into a space.

The circuit board 21 is a multilayer printed board on which the wireless circuit 22 and various electronic components are mounted. Near the center of the circuit board 21, the waveguide 23 penetrating from the front surface to the back surface of the circuit board 21 is provided. Note that the details of a circuit module including the circuit board 21 and the waveguide 23 will be described later.

The wireless circuit 22 is a wireless communication circuit that processes a millimeter wave transmitted and received by the antenna 42. The wireless circuit 22 is a single integrated circuit (IC) of Si, SiGe, GaAs, or the like, for example. Further, a package of such ICs and a module-type integrated together with another component on a board or the like are used, but these are illustrated as one rectangular parallelepiped component in the drawings. Note that, in an embodiment of the present disclosure, only the wireless circuit 22 is illustrated on the front surface of the circuit board 21 for the sake of convenience, and other mounted electronic components (such as a capacitor and an inductor) are omitted.

### Details of Waveguide 23

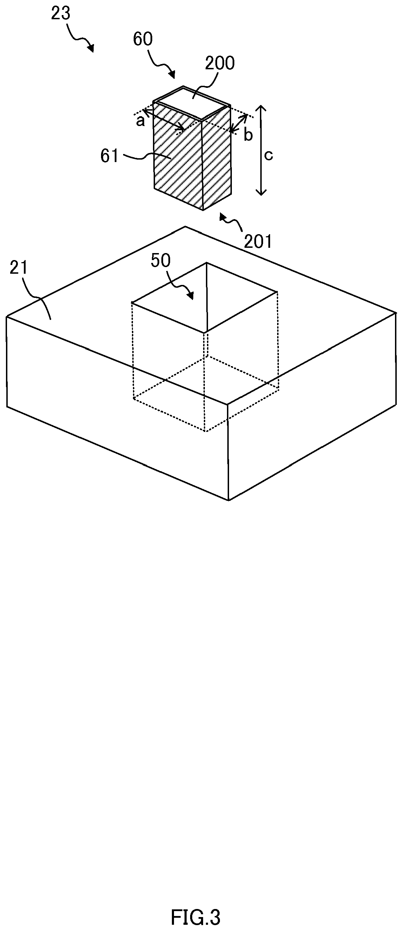

Fig. 3 is an exploded perspective view of the circuit board 21.

The waveguide 23 is provided between the wireless circuit 22 and the antenna 42, and propagates a signal received by the antenna 42 or a signal to be transmitted by the antenna 42. The waveguide 23 includes a propagation member 60 serving as a medium when a radio wave is transmitted, and a metal film 61 corresponding to a "pipe" being an outer shape of a typical hollow waveguide.

As illustrated in Fig. 3, the propagation member 60 is a rectangular parallelepiped member having a width a, a depth b, and a height c when a dielectric (such as quartz) that propagates a radio wave is used as a material, and a thickness direction of a board for insertion is defined as a height. Note that each dimension of the width a, the depth b, and the height c is given, for example, (a, b, c) = (3 mm, 1.5 mm, 6 mm) .

The metal film 61 is a film made of metal that covers side surfaces other than two surfaces of end parts (upper and lower surfaces in a height direction) of the propagation member 60. Specifically, the metal film 61 covers four surfaces other than a surface 200 (first surface) of the propagation member 60 on the front surface side of the circuit board 21 and a surface 201 (second surface) of the propagation member 60 on the back surface side of the circuit board 21. The metal film 61 is formed by performing, for example, metal film formation processing on the side surfaces of the propagation member 60. Note that the metal film 61 in an embodiment of the present disclosure is a copper film having such a thickness (for example, equal to or greater than 0.4 µm) as to sufficiently consider a skin effect in order to propagate a millimeter wave of 60 GHz, for example. However, for example, the metal film 61 may be a gold or silver film, and may be formed by plating process. Further, surface treatment may be performed so as to form two or more kinds of metals.

Further, producing a rectangular parallelepiped having the width a and the height b of about a few millimeters with high precision is generally easier than, for example, forming a through hole having the width a and the height b in a board with high precision. Thus, by using the propagation member 60 for the waveguide 23, it is possible to form an ideal waveguide 23 with corners having such a low degree of roundness that propagation is not affected.

### Details of Circuit Board 21

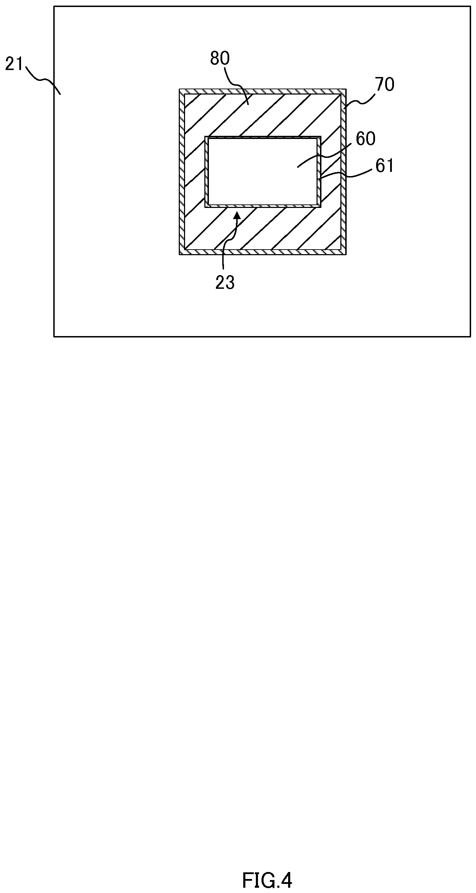

As illustrated in Fig. 3, a through hole 50 (for example, 4 mm × 2 mm) penetrating from the front surface to the back surface of the circuit board 21 is formed near the center of the circuit board 21. Further, the circuit board 21 has a thickness (6 mm) equal to the height c of the propagation member 60, for example. The through hole 50 is a rectangular parallelepiped hole formed by cutting, and openings in the front surface and the back surface have a rectangular shape. Note that, in practice, corners are rounded for manufacturing. Fig. 4 is a plan view of the circuit board 21. Although not illustrated in Fig. 3, a metal film 70 is formed on a surface of the periphery of the through hole 50 by, for example, plating process. Note that the metal film 70 in an embodiment of the present disclosure is, for example, copper, and is connected to ground wiring (ground part), which is not illustrated, of the circuit board 21.

The waveguide 23 is disposed near the center of the through hole 50, and a solder 80 for fixing the waveguide 23 in the through hole 50 fills between the waveguide 23 and the metal film 70 of the through hole 50. As a result, the metal film 70 of the through hole 50 and the metal film 61 of the waveguide 23 are electrically connected to each other via the solder 80. Further, since the metal film 70 is connected to the ground wiring (not illustrated) of the circuit board 21, the metal film 61 is also grounded. Accordingly, the waveguide 23 functions as a waveguide with a small transmission loss in a state of having been attached to the circuit board 21. Note that, here, the solder 80 is used for fixing the waveguide 23 in the through hole 50, but another conductive material such as a conductive resin including particles of silver and/or the like may be used.

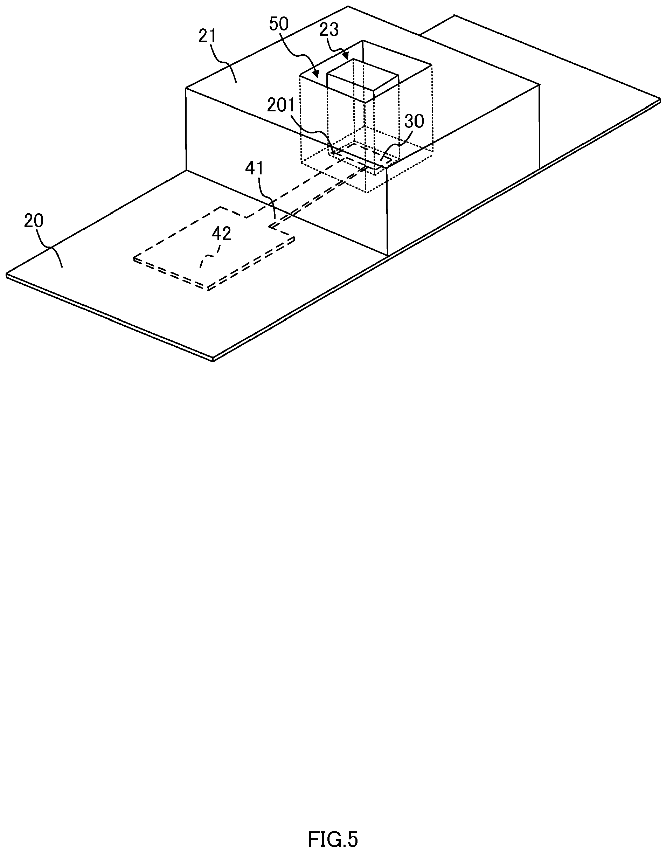

Fig. 5 is a perspective view illustrating a positional relationship among the antenna board 20, the circuit board 21, and the waveguide 23. Note that the metal film 61 and the like are omitted in Fig. 5 to facilitate understanding of the positional relationship of the waveguide 23 in the through hole 50.

The circuit board 21 in which the waveguide 23 is attached to the through hole 50 is mounted on the front surface of the antenna board 20. Specifically, the antenna board 20 and the circuit board 21 are mounted such that the lower surface 201 of the propagation member 60 of the waveguide 23 is electrically coupled to the coupling part 30 of the antenna board 20. Note that in a case where the coupling part 30 is located on the front surface of the antenna board 20 and contacts the propagation member 60 of the waveguide 23, the area of the coupling part 30 is made slightly smaller than the area of the surface 201 of the propagation member 60 so as to prevent the metal film 61 of the waveguide 23 from contacting the coupling part 30. Further, the antenna board 20 and the circuit board 21 are fixed with, for example, a conductive paste (not illustrated), and ground wiring (not illustrated) of the antenna board 20 and ground wiring (not illustrated) of the circuit board 21 are also connected to each other.

The wireless circuit 22 is mounted on the front surface of the circuit board 21. When the wireless circuit 22 is a single IC, an integrated circuit and pads for a power supply, signal input/output, and a ground connection are usually formed on one surface of the single IC. For example, the wireless circuit 22 is mounted by flip-chip mounting such that bumps are formed on the pads of the IC, the surface on the integrated circuit side faces the circuit board 21, and an area where a radio signal is radiated is positioned immediately above the propagation member. At this time, the pads of the IC for the power supply, the signal, and the ground are electrically connected to corresponding pads on the circuit board 21 side. Such connection is enhanced with an underfill material as necessary within bounds of not affecting propagation of a millimeter wave.

When the wireless circuit 22 is a wafer-level package, rewiring from pads of an IC is performed inside the wireless circuit. The wafer-level package typically has a shape having a greater pad interval and a greater pad size than those in the IC alone. The wafer-level package includes pads for a power supply, signal input/output, and a ground connection formed thereon, and allows mounting using solder balls and the like. Similarly to the case of the IC alone, the wireless circuit 22 is mounted by flip chip mounting such that an area where a wireless signal is radiated is positioned immediately above the propagation member. At this time, the pads of the IC for the power supply, the signal, and the ground are electrically connected to a corresponding pads on the circuit board 21 side. Such connection is enhanced with an underfill material as necessary within bounds of not affecting propagation of a millimeter wave.

When the wireless circuit 22 is a module including an IC chip and a peripheral component, the wireless circuit 22 is mounted by flip chip mounting such that an area where a wireless signal is radiated on the IC or an area where a wireless signal is radiated that has been drawn from the IC to a module board is positioned immediately above the propagation member. A method acquired by combining flip chip bonding or die bonding with wire bonding can be used for mounting the IC on the module board. Pads of the module board for a power supply, a signal, and a ground are electrically connected to corresponding pads on the circuit board 21 side.

In this way, the antenna 42 and the wireless circuit 22 communicate with each other using radio waves via the waveguide 23 including the propagation member 60, made of quartz, which serves as a medium. The propagation member 60 has a rectangular parallelepiped shape with corners having extremely low degree of roundness since the propagation member 60 is cut from quartz, for example. Accordingly, the waveguide 23 using the propagation member 60 can propagate radio waves in a desired mode using a desired frequency. Further, the waveguide 23 in an embodiment of the present disclosure passes through the through hole 50 and is fixed to the circuit board 21. Accordingly, in a case of using the circuit board 21 to which such a waveguide 23 is fixed, the size of the circuit board 21 can be reduced more than the size thereof in a case of using a typical hollow waveguide, for example.

### Method for Manufacturing Circuit Board 21 (Assembly Method)

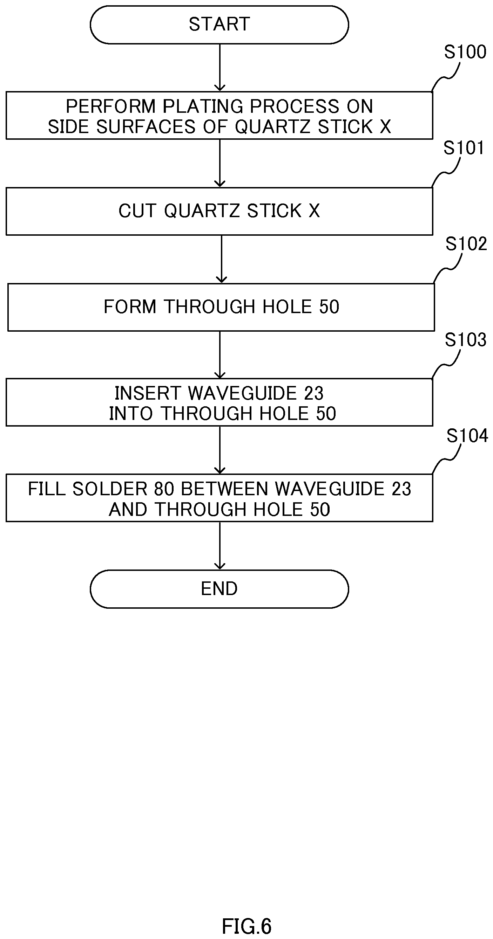

Fig. 6 is a flowchart illustrating one example of a method for manufacturing the circuit board 21. It is assumed here that a quartz stick X (not illustrated) having the same width a (3 mm) and the same depth b (1.5 mm) as those of the quartz propagation member 60 illustrated in Fig. 3 and a length (height c) of 100 mm, for example, is used.

First, a metal film is formed around this quartz stick X by, for example, plating (S100). Then, the quartz stick X is cut with, for example, a diamond grindstone such that the quartz stick has a predetermined length (here, a length set to a height of 6 mm of a finished product) (S101). At this time, in terms of maintaining the characteristics, a cut surface preferably has such a precision as to be equal to or less than one-tenth of a wavelength used.

Further, an operator forms the through hole 50 in the circuit board 21 (S102), and inserts the waveguide 23 into the through hole 50 (S103) . Furthermore, the operator fills a solder between the waveguide 23 and the through hole 50 (S104) . By this method, the waveguide 23 inserted into the circuit board 21 can be manufactured. Note that a quartz stick previously processed to have a predetermined width, depth, and height (here, 6 mm) may be prepared, and then plating process may be performed on only side surfaces. Note that, in the board manufacturing step, the circuit board 23 is subjected to a process of forming the through hole 50 and forming a metal film on the inner wall thereof.

As a result, as illustrated in Fig. 2, the waveguide 23 including a rectangular parallelepiped quartz as a medium is mounted into the through hole 50 of the circuit board 21.

### Other Embodiment of Circuit Board

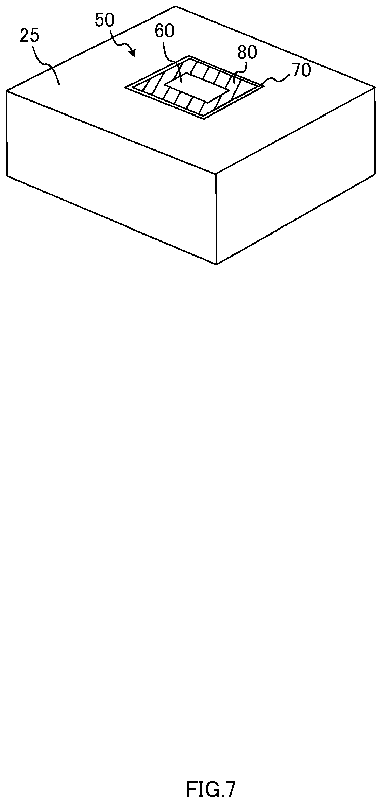

Fig. 7 is a perspective view of a circuit board 25. Note that elements of the circuit board 25 that are the same as those of the circuit board 21 are given the same reference numerals.

In the circuit board 25, a propagation member 60 is inserted into a through hole 50, and a solder 80 fills between the propagation member 60 and a metal film 70 of the through hole 50. Further, the solder 80 is grounded via the metal film 70 of the through hole 50. Thus, in the circuit board 25, the propagation member 60 is directly covered with the solder 80, so that the propagation member 60 and the solder 80 function as a waveguide. In this way, the waveguide configured with the propagation member 60 and the solder 80 is used in the circuit board 25. Accordingly, the size of the circuit board 25 can be reduced more than the size thereof when a typical hollow waveguide is used, for example. This can make it possible to use the circuit board 25 instead of the circuit board 21 in the wireless device 10, for example.

### Method for Manufacturing Circuit Board 25

A method for manufacturing the circuit board 25 is basically the same as the method for manufacturing the circuit board 21 illustrated in Fig. 6. However, the metal film 61 that covers the periphery of the propagation member 60 does not need to be formed in the circuit board 25. Thus, when the circuit board 25 is manufactured, Step S100 out of Steps S100 to S104 in Fig. 6 can be omitted. Further, a long quartz stick is not necessarily prepared and cut as in Step S101, but a quartz stick processed to have a predetermined width, depth, and height may be prepared.

### Summary

The wireless device 10 in an embodiment of the present disclosure has been described above. The waveguide including the propagation member 60 as a medium is formed in the through hole 50 in the circuit boards 21 and 25. In general, it is extremely easier to process quartz to form the propagation member 60 into a rectangular parallelepiped, which serves as a medium of a radio wave, as compared with forming, in a board, a rectangular through hole with each side of a few millimeters and corners having an extremely small R (radius of a rounded corner) with high precision. Accordingly, an ideal rectangular parallelepiped waveguide 23 capable of propagating a radio wave in a desired mode at a desired frequency can be formed by using the propagation member 60 processed from quartz. Further, the circuit boards 21 and 25 using such a propagation member 60 have the size smaller than that of a board using a typical hollow waveguide.

Further, the metal film 61 is formed on the side surfaces of the propagation member 60 by performing metal film formation processing in the circuit board 21. Thus, the circuit board 21 uses the waveguide 23 with small transmission loss where the propagation member 60 keeps a rectangular parallelepiped shape.

Further, the metal film 61 of the waveguide 23 is grounded via the solder 80. This can reduce reflection and transmission loss of a millimeter wave between the circuit board 21 and the waveguide 23.

Further, in the circuit board 25, the solder 80 fills between the metal film 70 of the through hole 50 and the propagation member 60, and the solder 80 is grounded via the metal film 70 of the through hole 50. In other words, in the circuit board 25, the propagation member 60 functions as a waveguide without performing the metal film formation processing or the like on the side surfaces of the propagation member 60. In this way, the circuit board 25 having a small size capable of propagating a radio wave from the front surface to the back surface can be achieved at a low cost in an embodiment of the present disclosure.

Further, the wireless device 10 can be configured such that the wireless circuit 22 that processes a signal from the waveguide 23 and the antenna board 20 that radiates a signal from the waveguide 23 are mounted onto the circuit boards 21 and 25.

Further, the circuit boards 21 and 25 having a small size capable of propagating a radio wave in a desired mode at a desired frequency can be manufactured by performing the steps illustrated in Fig. 6, and/or the like.

Note that the foregoing embodiments are for facilitating the understanding of the present disclosure, and are not to be construed as limiting the present disclosure. The present disclosure may be modified and/or improved without departing from the gist thereof, and the present disclosure encompasses any equivalents thereof.

The wireless device 10 in an embodiment of the present disclosure transmits and receives a millimeter wave of 60 GHz, but the present disclosure is not limited thereto. For example, the wireless device 10 is also used for transmitting and receiving a radio wave in a band of a few tens of GHz to a few hundreds of GHz. Note that, at this time, the width a and the height b of the propagation member 60 are changed accordingly.

Further, the propagation member 60 in an embodiment of the present disclosure is quartz, but may be, for example, a dielectric that propagates a radio wave of a desired frequency.

Further, for example, the height c of the propagation member 60 is equal to a thickness of the circuit board 21, but may be different therefrom.

Further, the through hole 50 of the circuit boards 21 and 25 is covered with the metal film 70, but the metal film 70 may not be provided. In such a case, the solder 80 may be directly connected to the ground wiring of the circuit boards 21 and 25.

Further, the antenna 42 that transmits and receives a millimeter wave has a substantially rectangular shape, but the present disclosure is not limited thereto. The antenna 42 may be a pattern having another shape such as a square and a circle.

The plating process is used as the metal film formation processing in an embodiment of the present disclosure, but the present disclosure is not limited thereto. For example, processing such as vapor deposition, sputtering, and baking may be used as the metal film formation processing.

### [Reference Signs List]

- 10:: Wireless device;
- 20:: Antenna board;
- 21, 25:: Circuit board;
- 22:: Wireless circuit;
- 23:: Waveguide;
- 30:: Coupling part;
- 41:: Signal line;
- 42:: Antenna;
- 50:: Through hole;
- 60:: Propagation member;
- 61, 70:: Metal film;
- 80:: Solder;
- 200, 201:: Surface (first surface, second surface).

## Claims

1. A circuit board comprising:
a through hole that penetrates between a front surface and a back surface of the circuit board; and
a waveguide formed in the through hole, the waveguide including a dielectric having a rectangular parallelepiped shape and a conductor covering surfaces other than a first surface and a second surface of the dielectric, the first surface being on a front surface side of the circuit board, the second surface being on a back surface side of the circuit board.

2. The circuit board according to claim 1, wherein
the conductor is formed by performing metal film formation processing on the surfaces other than the first surface and the second surface of the dielectric.

3. The circuit board according to claim 2, further comprising
a conductive material that fills between the conductor and the through hole, and connects the conductor to a ground part of the circuit board.

4. The circuit board according to claim 1, wherein
the conductor is a conductive material that fills between the through hole and the surfaces other than the first surface and the second surface of the dielectric, and is connected to a ground part of the circuit board.

5. A wireless device comprising:
the circuit board according to any one of claims 1 to 4; and
a wireless circuit that is mounted on the circuit board, and processes a signal from the waveguide.

6. A wireless device comprising:
the circuit board according to any one of claims 1 to 4; and
an antenna board that is connected to the circuit board, and includes an antenna that radiates a signal from the waveguide.

7. A method for manufacturing a circuit board, the method comprising:
forming a through hole that penetrates between a front surface and a back surface of the circuit board;
inserting, into the through hole, a waveguide that includes a dielectric having a rectangular parallelepiped shape and a conductor covering surfaces other than a first surface and a second surface of the dielectric, the first surface and the second surface being on a front surface side and a back surface side of the circuit board, respectively, when the dielectric has been inserted into the through hole; and
filling a conductive material between the waveguide and the through hole.

8. A method for manufacturing a circuit board, the method comprising:
forming a through hole that penetrates between a front surface and a back surface of the circuit board;
inserting a dielectric having a rectangular parallelepiped shape into the through hole; and
filling a conductive material between the dielectric and the through hole, and forming a waveguide in which surfaces other than a first surface and a second surface of the dielectric are covered with the conductive material, the first surface being on a front surface side of the circuit board, the second surface being on a back surface side of the circuit board.
